(19) Europäisches Patentamt
European Patent Office
Office européen des brevets

(11) **EP 1 793 434 A1**

(12) **EUROPEAN PATENT APPLICATION**
published in accordance with Art. 158(3) EPC

(43) Date of publication:
06.06.2007 Bulletin 2007/23

(51) Int Cl.:
*H01L 43/10* [(2006.01)]   *H01L 43/08* [(2006.01)]
*H01L 43/12* [(2006.01)]   *H01L 27/105* [(2006.01)]

(21) Application number: 05780398.3

(22) Date of filing: 11.08.2005

(86) International application number:
PCT/JP2005/015044

(87) International publication number:
WO 2006/022183 (02.03.2006 Gazette 2006/09)

(84) Designated Contracting States:
DE FR

(30) Priority: 27.08.2004 JP 2004248071
28.10.2004 JP 2004313253

(71) Applicant: Japan Science and Technology Agency
Kawaguchi-shi,
Saitama 332-0012 (JP)

(72) Inventor: YUASA, Shinji,
National Institute Advanced Ind. Science and Tech
Tsukuba-shi,
Ibaraki 305-8568 (JP)

(74) Representative: Hengelhaupt, Jürgen et al
Gulde Hengelhaupt Ziebig & Schneider
Wallstrasse 58/59
10179 Berlin (DE)

(54) **MAGNETORESISTACNE ELEMENT AND PRODUCTION METHOD THEREFOR**

(57) A single crystal MgO (001) substrate (11) is provided, a 50nm-thick epitaxial Fe(001) lower electrode (first electrode) (17) is grown on an MgO (001) seed layer (15) at room temperature, then it is annealed at 350æC in ultra-high vacuum ($2 \times 10^{-8}$Pa). A 2nm-thick MgO(001) barrier layer (21) is epitaxially grown on the Fe(001) lower electrode (first electrode) (17)at room temperature using an MgO electron beam vapor deposition. A 10nm-thick Fe (001) upper electrode (second electrode) (23) is formed on the MgO(001) barrier layer (21) at room temperature. Continuously, a 10nm-thick IrMn layer (25) is deposited on the Fe(001) upper electrode (second electrode (23). The IrMn layer (25) is used to realize an antiparallel magnetizing arrangement by imparting an exchange bias magnetic field to the upper electrode (23). Next, the above fabricated sample is micro-fabricated to form an Fe(001)/MgO(001)/Fe(001) TMR element to thereby increase the MR ratio of the TMR.

FIG. 2 (A)

FIG. 2 (B)

| | |
|---|---|
| 5 | Fe(001) |
| 3 | MgO(001) |
| 1 | Fe(001) |

**Description**

BACKGROUND OF THE INVENTION

Field of the Invention

The present invention relates to a magnetic tunnel junction device and a method of manufacturing the same, particularly to a magnetic tunnel junction device with a high magnetoresistance and a method of manufacturing the same.

Description of Related Art

Magnetoresistive random access memories (MRAMs) refer to a large-scale integrated memory circuit that is expected to replace the currently widely used DRAM memories. Research and development of MRAM devices, which are fast and non-volatile memory devices, are being extensively carried out, and sample products of a 4Mbit MRAM have actually been delivered.

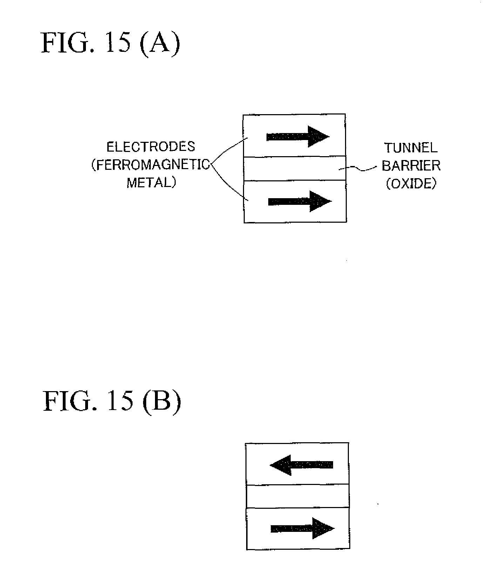

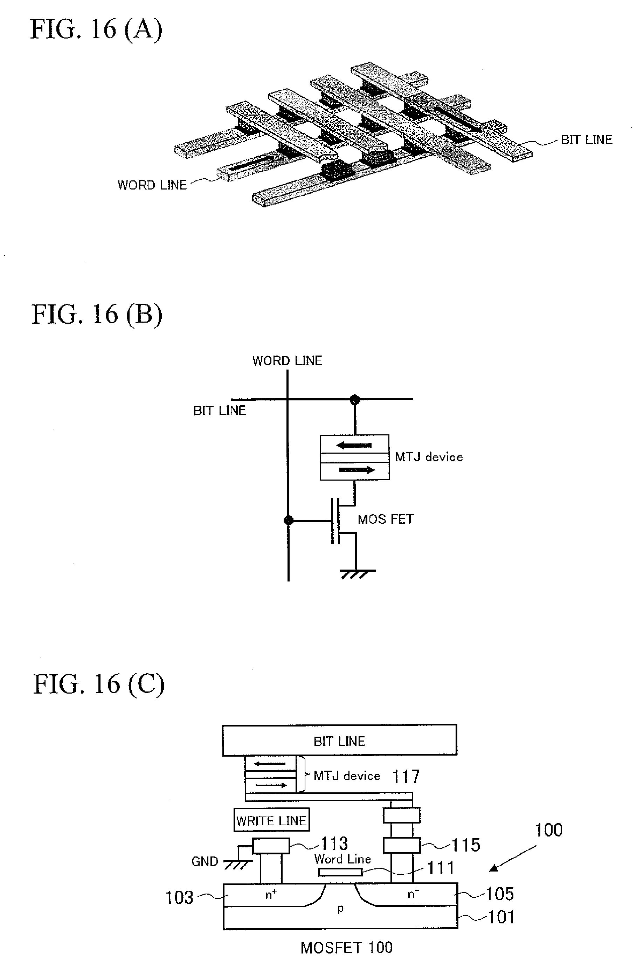

Fig. 15 shows the structure and operation principle of a magnetic tunnel junction device (to be hereafter referred to as a "MTJ device"), which is the most important part of the MRAM. As shown in Fig. 15(A), a MTJ device comprises a tunneling junction structure in which a tunnel barrier (to be hereafter also referred to as a "barrier layer") made of an oxide is sandwiched between a first and a second electrode made of a ferromagnetic metal. The tunnel barrier layer comprises an amorphous Al-O layer (see D. Wang, et al.: Science 294 (2001) 1488.). As shown in Fig. 15(A), in the case of parallel magnetization alignment where the directions of magnetizations of the first and second ferromagnetic electrodes are aligned parallel, the electric resistance of the device with respect to the direction normal to the interfaces of the tunneling junction structure decreases. On the other hand, in the case of antiparallel magnetization alignment where the directions of magnetizations of the first and second ferromagnetic electrodes are aligned antiparallel as shown in Fig. 15(B), the electric resistance with respect to the direction normal to the interfaces of the tunneling junction structure increases. The resistance value does not change in a general state, so that information "1" or "0" can be stored depending on whether the resistance value is high or low. Since the parallel and antiparallel magnetization alignments can be stored in a non-volatile fashion, the device can be used as a non-volatile memory device. Fig. 16 shows an example of the basic structure of MRAM. Fig. 16(A) shows a perspective view, and Fig. 16(B) schematically shows a circuit block diagram. Fig. 16(C) is a cross-section of an example of the structure of MRAM. Referring to Fig. 16(A), in an MRAM, a word line WL and a bit line BL are disposed in an intersecting manner, with an MRAM cell disposed at each intersection. As shown in Fig. 16(B), the MRAM cell disposed at the intersection of a word line and a bit line comprises a MTJ device and a MOSFET connected in series with the MTJ device. Stored information can be read by reading the resistance value of the MTJ device, which functions as a load resistance, using the MOSFET. Stored information can be rewritten by applying a magnetic field to the MTJ device, for example. As shown in Fig. 16(C), an MRAM memory cell comprises a MOSFET 100 including a source region 105 and a drain region 103 both formed inside a p-type Si substrate 101, and a gate electrode 111 formed on a channel region that is defined between the source and drain regions. The MRAM also comprises a MTJ device 117. The source region 105 is grounded, and the drain is connected to a bit line BL via the MTJ device. A word line WL is connected to the gate electrode 111 in a region that is not shown.

Thus, a single non-volatile MRAM memory cell can be formed of a single MOSFET 100 and a single MTJ device 117. The MRAM therefore provides a memory device suitable for high levels of integration.

SUMMARY OF THE INVENTION

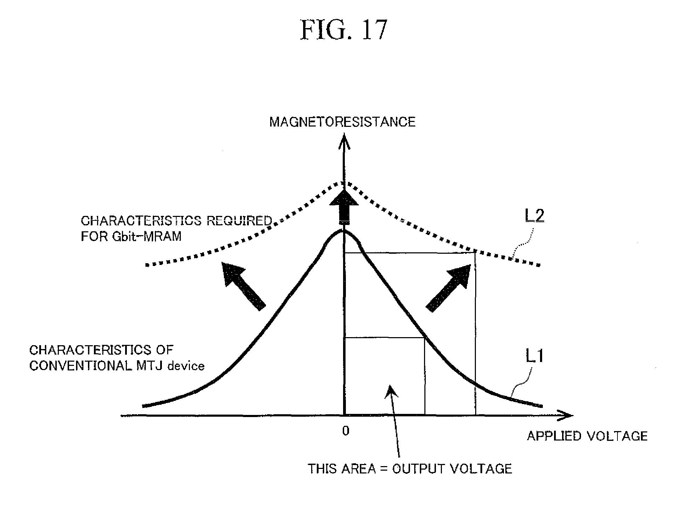

Although there are prospects for achieving MRAMs with capacities on the order of 64Mbits based on the current technologies, the characteristics of the MTJ device, which is the most important part of MRAM, need to be improved if higher levels of integration are to be achieved. In particular, in order to increase the output voltage of the MTJ device, the magnetoresistance must be increased and the bias voltage characteristics must be improved. Fig. 17 illustrates how the magnetoresistance in a conventional MTJ device using an amorphous Al-O as the tunnel barrier changes as a function of the bias voltage (L1). As shown, in the conventional MTJ device, the magnetoresistance is small and, notably, it tends to drastically decrease upon application of bias voltage.

With such characteristics, the output voltage when operation margins are taken into consideration is too small for the device to be employed for an actual memory device. Specifically, the magnetoresistance of the current MTJ device is small at approximately 70%, and the output voltage is also small at no more than 200 mV, which is substantially half the output voltage of a DRAM. This has resulted in the problem that as the level of integration increases, signals are increasingly lost in noise and cannot be read.

It is an object of the invention to provide a memory device with a high magnetoresistance for stable operation.

In one aspect, the invention provides a magnetic tunnel junction device of a magnetic tunnel junction structure comprising: a tunnel barrier layer; a first ferromagnetic material layer of the BCC structure formed on a first plane of the tunnel barrier layer; and a second ferromagnetic material layer of the BCC structure formed on a second plane of the tunnel barrier layer, wherein the tunnel barrier layer is formed of a single-crystalline $MgO_x$ (001) or a poly-crystalline $MgO_x$ ($0 < x < 1$) layer (to be hereafter referred to as "an MgO layer") in which the (001) crystal plane is preferentially oriented. The atoms of which the second ferromagnetic material layer is comprised are disposed above the O atoms of the MgO tunnel barrier layer. In this magnetic tunnel junction device, because the atoms making up the ferromagnetic material layer are disposed above the O atoms of the MgO layer, the MR ratio can be increased.

In another aspect, the invention provides a magnetic tunnel junction device of a magnetic tunnel junction structure comprising: a tunnel barrier layer; a first ferromagnetic material layer of the BCC structure formed on a first plane of the tunnel barrier layer; and a second ferromagnetic material layer of the BCC structure formed on a second plane of the tunnel barrier layer, wherein the tunnel barrier layer is formed of a single-crystalline $MgO_x$ (001) or a poly-crystalline $MgO_x$ ($0 < x < 1$) layer (to be hereafter referred to as "an MgO layer") in which the (001) crystal plane is preferentially oriented. This magnetic tunnel junction device utilizes the fact that tunneling probability of carriers are enhanced as the wave functions of the $\Delta 1$ band of at least one of the first or second ferromagnetic material layer with the BCC structure seeps into the MgO layer.

The MgO layer characteristically comprises a film thickness such that the wave functions therein enhance the tunneling probability. For example, the film thickness of the MgO (001) layer is preferably 1.49 nm, 1.76 nm, 2.04 nm, 2.33 nm, 2.62 nm, or 2.91 nm, with a margin of - 0.05 nm to + 0.10 nm for each of the values. More preferably, the MgO (001) layer has a thickness of 1.49 nm, 1.76 nm, 2.04 nm, 2.33 nm, 2.62 nm, or 2.91 nm, with a margin of + 0.05 nm for each of the values.

The invention also provides a memory device capable of stable operation which comprises a single transistor and the aforementioned magnetic tunnel junction device as a load for the transistor.

In yet another aspect, the invention provides a method for manufacturing a magnetic tunnel junction device, comprising:

forming a first single-crystalline (001) or poly-crystalline layer of Fe or an Fe-based alloy of the BCC structure (to be hereafter referred to as "an Fe layer"), said poly-crystalline layer having the (001) crystal plane preferentially oriented therein;

depositing a single-crystalline $MgO_x$ (001) or a poly-crystalline $MgO_x$ ($0 < x < 1$) layer in which the (001) crystal plane is preferentially oriented (to be hereafter referred to as "a MgO layer") on said first Fe layer under high vacuum by electron beam evaporation, for example, and then annealing under ultrahigh vacuum at temperature ranging from 200°C to 300°C; and forming a second Fe layer on the tunnel barrier layer. By annealing at temperature ranging from 200°C to 300°C under ultrahigh vacuum, a clean MgO surface can be formed, which can be used as a basis for the regular growth of the subsequent second Fe layer, particularly a flat structure such that Fe atoms are disposed above the O atoms of MgO and no O atoms are present in the Fe layer. The step for forming the second Fe layer on the MgO layer is characteristically performed at the substrate temperature of 150°C to 250°C. In this way, a structure can be grown where Fe atoms are disposed above the O atoms of MgO.

The invention further provides a method for manufacturing a magnetic tunnel junction device, comprising:

a first step of preparing a substrate comprising a single-crystalline $MgO_x$ (001) or a poly-crystalline $MgO_x$ ($0 < x < 1$) in which the (001) crystal plane is preferentially oriented;

a second step of depositing on the substrate a first single-crystalline (001) or poly-crystalline layer of Fe or an Fe alloy of the BCC structure, the poly-crystalline layer having the (001) crystal plane preferentially oriented therein, and then annealing for surface planarization purposes;

a third step of depositing, under high vacuum, a tunnel barrier layer on the first (001) layer of Fe or an Fe alloy of the BCC structure, the tunnel barrier layer comprising single-crystalline $MgO_x$ (001) or poly-crystalline $MgO_x$ ($0 < x < 1$) in which the (001) crystal plane is preferentially oriented, and then annealing at temperature ranging from 200°C to 300°C; and

a fourth step of forming a second single-crystalline (001) or poly-crystalline layer of Fe or an Fe alloy of the BCC structure on the tunnel barrier layer, the poly-crystalline layer having the (001) crystal plane preferentially oriented therein.

In this method, an interface structure with better crystallinity and higher magnetoresistance can be created in a device comprising a tunnel barrier layer of a single-crystalline $MgO_x$ (001) or a poly-crystalline $MgO_x$ ($0 < x < 1$) in which the (001) crystal plane is preferentially oriented.

In yet another aspect, the invention provides a magnetic tunnel junction device of a magnetic tunnel junction structure comprising:

a tunnel barrier layer;

a first ferromagnetic material layer comprising an amorphous magnetic alloy formed on a first plane of the tunnel barrier layer; and

a second ferromagnetic material layer comprising an amorphous magnetic alloy formed on a second plane of the tunnel barrier layer,

wherein the tunnel barrier layer is formed of a single-crystalline $MgO_x$ (001) or a poly-crystalline $MgO_x$ (0 < x < 1) layer in which the (001) crystal plane is preferentially oriented (to be hereafter referred to as "a MgO layer"),

wherein the wave functions of conduction electrons in the first and/or the second ferromagnetic layer are caused to seep into the $\Delta1$ band of the MgO layer such that the tunneling probabilities of the carriers are enhanced.

BRIEF DESCRIPTION OF THE DRAWINGS

Fig. 1 shows an example of the structure of Fe (001)/MgO (001) interface. Fig. 1(A) shows an ideal interface structure in which the Fe atoms at the interface are disposed above the O atoms of MgO. Fig. 1(B) shows an interface structure in which the Fe atoms at interface are disposed above the Mg atoms of MgO. Fig. 1(C) shows a structure in which oxygen atoms are disposed between the Fe atoms at the interface, where the Fe atoms at the interface are oxidized.

Fig. 2 shows the structure of a MTJ device (Fig. 2(B)) according to a first embodiment of the invention, and the energy band structure of Fe (001) (Fig. 2(A)), which is a ferromagnetic metal. Fig. 2(A) shows the $E-E_F$ dispersion relationship with respect to the [001] direction in a wave-vector space, in which a majority spin band is indicated by solid lines and a minority band by broken lines.

Fig. 3(A) to (D) schematically shows the process of manufacturing a magnetic tunnel junction device with a Fe (001) /MgO (001)/Fe (001) structure (to be hereafter referred to as "a Fe (001)/MgO (001)/Fe (001) MTJ device") according to an embodiment of the invention.

Fig. 4(A) shows a RHEED image of a Fe (001) lower electrode (first electrode) 17 (with the direction of incident electron beam in the Fe [110] direction and acceleration voltage of 20 kV). Fig. 4(B) shows a RHEED image of a MgO (001) barrier layer 21 (with the direction of incident electron beam in the MgO [100] direction and the acceleration voltage of 20 kV).

Fig. 5 shows cross-sectional transmission electron microscope images of the MTJ device, Fig. 5(B) showing an enlarged view of Fig. 5(A).

Fig. 6(A) shows the X-ray absorption spectrum (XAS) of the L2 and L3 absorption edges of the Fe atoms in the interface atomic layer of the MTJ device. Fig.6(B) shows the X-ray absorption spectrum (XAS) of a device in which a Fe (001) upper electrode (second electrode) 23 has been deposited at room temperature without performing the annealing of the MgO (001) barrier layer 21 at ultrahigh vacuum.

Fig. 7 shows the $T_{sub}$ dependence of $MR_{max}$ in a case where, following the growth of the MgO (001) tunnel barrier, annealing was performed at 300°C in ultrahigh vacuum, and in a case where, following the growth of the MgO (001) tunnel barrier, the Fe (001) upper electrode was grown at a substrate temperature $T_{sub}$ without performing annealing.

Fig. 8 shows the $T_{sub}$ dependence of $MR_{max}$ in a case where, following the growth of the MgO (001) tunnel barrier, the Fe (001) upper electrode was grown at a substrate temperature $T_{sub}$ after annealing in ultrahigh vacuum at 300°C.

Fig. 9 shows an example of the magnetoresistance curve in the MTJ device of an embodiment of the invention, showing experimental data obtained with the MgO barrier thickness of 2.33 nm, measurement temperature of 293K, and the applied voltage of 30 mV.

Fig. 10 shows the MgO thickness ($t_{MgO}$) dependence of the magnetoresistance ratio (MR ratio) in a case where, following the growth of the MgO (001) tunnel barrier and annealing in ultrahigh vacuum at 300°C, the Fe(001) upper electrode was grown at substrate temperature of 200°C.

Fig. 11 shows the local density of state (LDOS) in a Fe/Al-O/Fe MTJ device and distribution of the phase of wave functions.

Fig. 12 shows the local density of state (LDOS) of a Fe (001)/MgO (001)/Fe (001) MTJ device, and the distribution of the phase of wave functions.

Fig. 13 shows the MgO thickness ($t_{MgO}$) dependence of the electric resistance (RA) of a device in a case where, following the growth of the MgO (001) tunnel barrier and annealing in ultrahigh vacuum at 300°C, the Fe(001) upper electrode was grown at substrate temperature of 200°C.

Fig. 14 shows the RA dependence of MR ratio in a case where, following the growth of the MgO (001) tunnel barrier and annealing in ultrahigh vacuum at 300°C, the upper electrode Fe (001) was grown at substrate temperature of 200°C.

Fig. 15(A) and (B) shows the structure of a MTJ device and its operational principle.

Fig. 16 shows an example of the basic structure of an MRAM, Fig. 16(A) showing a perspective view of the MRAM, Fig. 16(B) showing a schematic circuit diagram, and Fig. 16(C) showing a cross section of an example of the MRAM.
Fig. 17 shows a change in the magnetoresistance of a conventional MTJ device comprising an amorphous Al-O as a tunnel barrier, depending on bias voltage.
Fig. 18 shows the structure of a variation of the MTJ device of the invention, which corresponds to Fig. 2(B).

DESCRIPTION OF THE PREFERRED EMBODIMENTS

In the present specification, because MgO has a cubic crystal structure, the (001) plane, the (100) plane, and the (010) plane are all equivalent. The direction perpendicular to the film surface is herein considered to be the z-axis so that the film plane can be uniformly described as (001). Also in the context of the present specification, the BCC structure, which is the crystalline structure of an electrode layer, means the body-centered cubic lattice structure. More specifically, the BCC structure includes a BCC structure with no chemical order, or the so-called A2-type structure, a BCC structure with chemical order, such as B2-type structure and $L2_1$-type structure, and also the aforementioned structures with slight lattice distortion.

The term "ideal value" with regard to a perfect single-crystal without defect herein refers to a value that has been estimated from ultraviolet photoemission spectroscopy experiments (see W. Wulfhekel, et al.: Appl. Phys. Lett. 78 (2001) 509.). The term "ideal value" is used herein because the aforementioned state can be considered to be an upper limit value of the potential barrier height of the tunnel barrier of an ideal single-crystalline MgO with almost no oxygen vacancy defects or lattice defects.

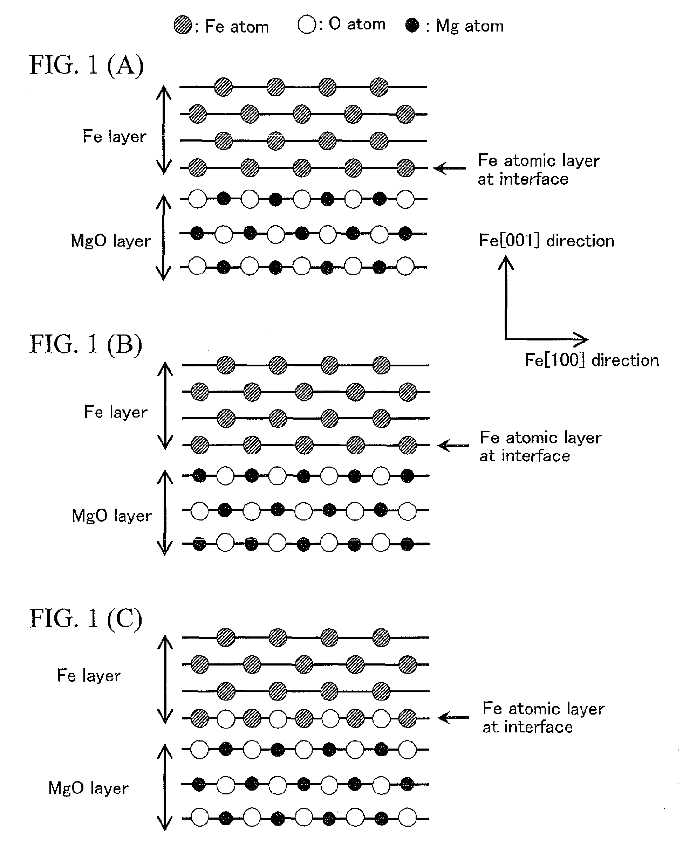

Before describing the preferred embodiments of the invention, an analysis conducted by the inventors is discussed. The inventors have conducted experiments regarding the Fe/MgO structure and have gained a variety of insights into it. Fig. 1(A) shows a typical structure of the Fe/MgO interface. In the structure shown, where Fe in the first atomic layer of the interface is disposed above the O atoms of MgO, it is theoretically predicted that a huge magnetoresistance would appear (W. H. Butler, X. G. Zhang, et al., Phys. Rev. B63, 054416 (2001).).

On the other hand, in the structure shown in Fig. 1(B), where Fe of the first atomic layer of the interface is above the Mg atoms of MgO, no huge magnetoresistance would appear. Nor would it appear when O atoms exist on either side of Fe atoms of the first atomic layer of the interface, as shown in Fig. 1(C) (H. L. Meyerheim, et al., Phys. Rev. Lett. 87, 76102 (2001). H. L. Meyerheim, et al., Phys. Rev. B. 65, 144433 (2002). X. G. Zhang, W. H. Bulter, et al., Phys. Rev. B. 68, 92402 (2003)).

Thus, in order to realize a huge magnetoresistance, a method must be established whereby an ideal structure as shown in Fig. 1(A) can be manufactured.

The magnetoresistance (MR) ratio of a MTJ device can be expressed by the following equation:

$$\text{MR ratio} = \Delta R/Rp = (Rap - Rp)/Rp$$

where Rp and Rap indicate the tunnel junction resistance in the cases of parallel and antiparallel magnetization alignments, respectively, of two electrodes. According to the Jullire's formula, the MR ratio at low bias voltage can be expressed by:

$$\text{MR ratio} = (Rap - Rp)/Rp = 2P_1P_2/(1-P_1P_2),$$

$$\text{where } P\alpha = (D\alpha \uparrow (E_F) - D\alpha \downarrow (E_F))/(D\alpha \uparrow (E_F) + D\alpha \downarrow (E_F)), \text{ and } \alpha = 1, 2 \quad (1)$$

In the above equations, $P\alpha$ is the spin polarization of an electrode, and $D\alpha \uparrow (E_F)$ and $D\alpha \downarrow (E_F)$ are the densities of state (DOS) at the Fermi energy ($E_F$) of the majority-spin band and the minority-spin band, respectively. Since the spin polarization of ferromagnetic transition metals and alloys is approximately 0.5 or smaller, the Jullire's formula predicts the highest estimated MR ratio of about 70%.

Although the MR ratio of approximately 70% has been obtained at room temperature when a MTJ device was made using an amorphous Al-O tunnel barrier and poly-crystalline electrodes, it has been difficult to obtain the output voltage of 200 mV, which is comparable to the output voltages of DRAMs. This is one of the biggest problems to be solved before high-density MRAMs mentioned above can be realized.

The inventors tried an approach to fabricate a MTJ device in which the tunnel barrier comprises a single-crystal (001) of magnesium oxide (to be hereafter referred to as "MgO") or a poly-crystalline MgO in which the (001) crystal plane is preferentially oriented. It is the inventors' theory that, because magnesium oxide is a crystal (where the atoms are located in an orderly fashion), as opposed to the conventional amorphous Al-O barrier, electrons are not scattered and coherency of electrons' wave functions is conserved during the tunneling process.

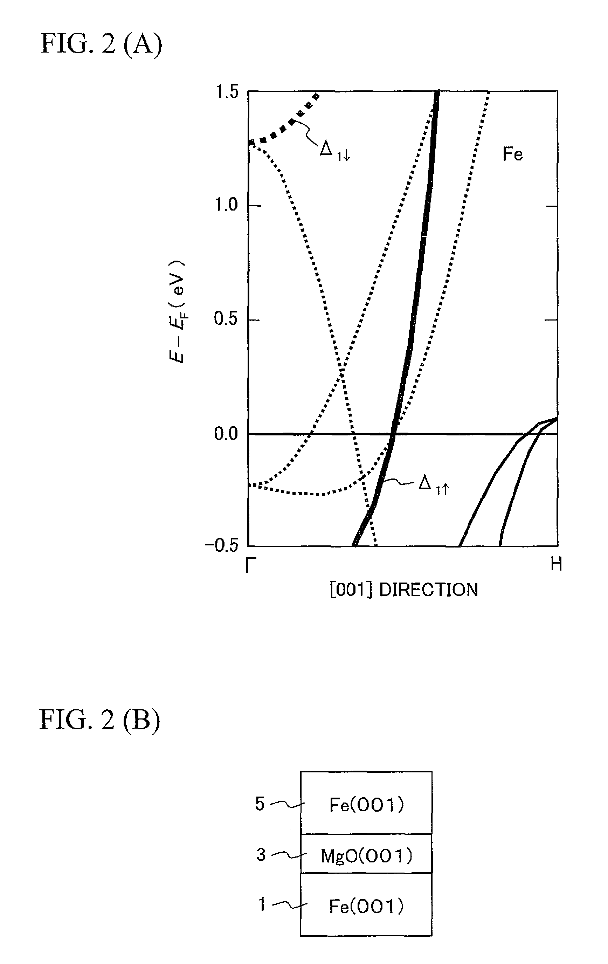

Fig. 2(B) shows the MTJ device structure according to an embodiment of the invention. Fig. 2(A) shows the energy band structure of the ferromagnetic Fe(001), that is, the $E-E_F$ relationship with respect to the [001] direction of the wave-vector space. As shown in Fig. 2(B), the MTJ device structure of the present embodiment comprises a first Fe (001) layer 1, a second Fe (001) layer 5, and a single-crystalline $MgO_x$ (001) or a poly-crystalline $MgO_x$ ($0 < x < 1$) layer 3 sandwiched therebetween, the poly-crystalline layer having the (001) crystal plane preferentially oriented therein.

According to the aforementioned Jullire's model, assuming that the momentum of conduction electrons is conserved in the tunneling process, the tunneling current that passes through MgO would be dominated by those electrons with wave vector k in the direction perpendicular to the tunnel barrier (i.e., normal to the junction interfaces). In accordance with the energy band diagram shown in Fig. 2(A) of Fe in the [001] (Γ-H) direction, the density of state (DOS) at the Fermi energy $E_F$ does not exhibit a very high spin polarization due to the fact that the sub-bands of the majority-spin and the minority-spin have states at the Fermi energy $E_F$. However, in case the coherency of electrons is conserved in the tunneling process, only those conduction electrons that have totally symmetrical wave functions with respect to the axis perpendicular to the barrier would be coupled with the states in the barrier region and come to have a large tunneling probability. In the case of Fe(001) electrode, electrons in the $\Delta_1$ band have such totally symmetric wave functions.

As shown in Fig. 2(B), the majority-spin $\Delta_1$ band (solid line) of Fe has states at the Fermi energy $E_F$, whereas the minority-spin $\Delta_1$ band (broken line) of Fe does not have states at the Fermi energy $E_F$. Because of such half-metallic characteristics of the Fe-$\Delta_1$ band, it can be expected that a very high MR ratio can be obtained in a coherent spin-polarized tunneling. Since the scattering of electrons is suppressed during the tunneling process in an epitaxial (single-crystal, or (001)-oriented poly-crystal) MTJ device, an epitaxial MTJ device is thought to be ideal for realizing the aforementioned coherent tunneling.

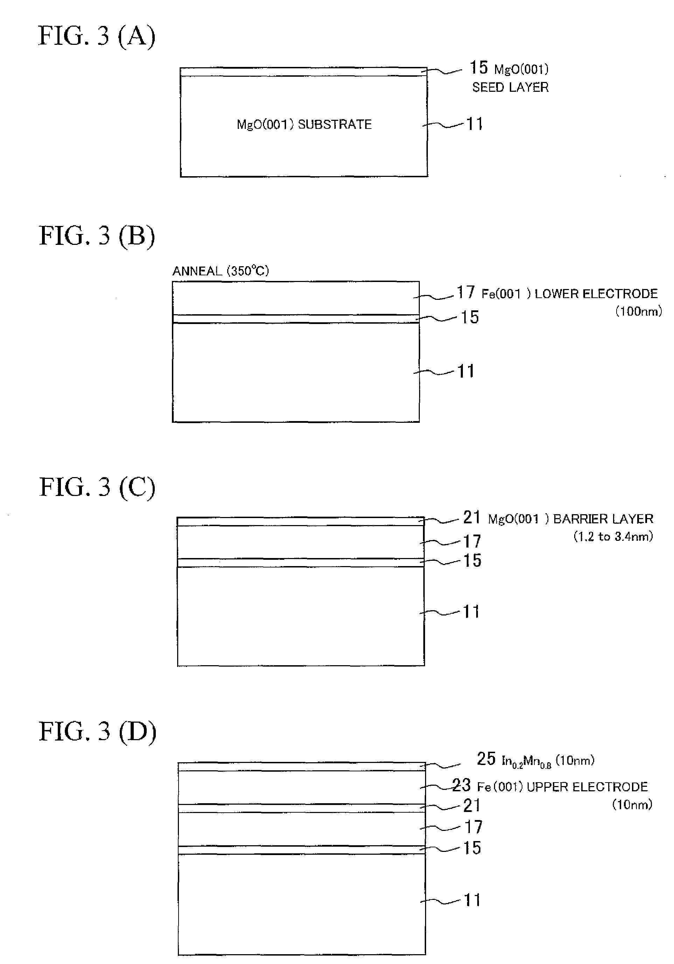

In the following, a MTJ device according to a first embodiment of the invention and a method of manufacturing the same will be described with reference to the drawings. Figs. 3(A) to 3(D) schematically show the method of manufacturing the MTJ device having the Fe (001)/MgO(001)/Fe(001) structure according to the embodiment (to be hereafter referred to as a "Fe(001)/MgO(001)/Fe(001) MTJ device"). Fe refers to a ferromagnetic material with the BCC structure. First, a single-crystalline MgO(001) substrate 11 is prepared. In order to improve the morphology of the surface of the single-crystalline MgO(001) substrate 11, a MgO(001) seed layer 15 is grown by the molecular beam epitaxy (MBE) method, for example. This is subsequently followed by the growth of an epitaxial Fe(001) lower electrode (first electrode) 17 with a thickness of 100 nm on the MgO(001) seed layer 15 at room temperature, as shown in Fig. 1(B). Annealing is then performed at 350°C under ultrahigh vacuum ($2 \times 10^{-8}$ Pa), whereby the surface of the Fe (001) lower electrode (first electrode) 17 can be made so flat that there is little atomic steps thereon.

The electron-beam evaporation conditions include an acceleration voltage of 8 kV, a growth rate of 0.02 nm/sec, and the growth temperature of room temperature (about 293K). The source material for the electron-beam evaporation is MgO of the stoichiometric composition (the ratio of Mg to O atoms being 1:1), the distance between the source and the substrate is 40 cm, the base vacuum pressure is $1 \times 10^{-8}$ Pa, and the $O_2$ partial pressure is $8 \times 10^{-7}$ Pa. Alternatively, a source with oxygen deficiency may be used instead of the MgO of the stoichiometric composition (the ratio of Mg to O atoms being 1:1).

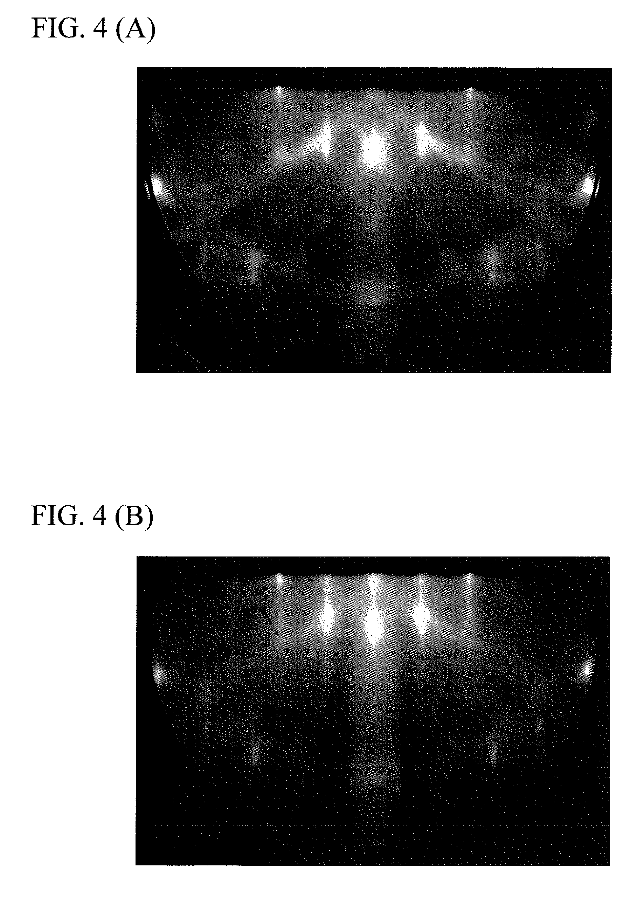

Fig. 4(A) shows a RHEED image of the Fe(001) lower electrode (first electrode) 17 (where the direction of the incident electron beam is the Fe [110] direction, and the acceleration voltage is 20 kV). The image shows that the Fe (001) lower electrode (first electrode) 17 possesses a good crystallinity and flatness.

Thereafter, as shown in Fig. 3(C), a MgO(001) barrier layer 21 with a thickness of t (from 1.2 nm to 3.4 nm) was epitaxially grown on the Fe(001) lower electrode (first electrode) 17 at room temperature, also using MgO source material. Thereafter, annealing is performed at 300°C in high vacuum, whereby Mg and O are caused to be regularly arranged and the oxygen and water that have mainly been adsorbed on the surface can be evaporated. As a result, a flat and clean MgO surface can be formed. Annealing temperature is preferably 200°C or higher. The surface of the MgO (001) barrier layer 21 can also be made very smooth due to the smoothness of the surface of the Fe (001) lower electrode (first electrode) 17.

Fig. 4(B) shows a RHEED image of the MgO(001) barrier layer 21. As shown in Fig. 4(B) (where the direction of the incident electron beam is the MgO [100] direction, and the acceleration voltage is 20 kV), the MgO(001) barrier layer 21 also possesses a good crystallinity and flatness.

Then, a Fe (001) upper electrode (second electrode) 23 was formed on the MgO (001) barrier layer 21 to the thickness of 10 nm at a substrate temperature Ts, which will be described later, as shown in Fig. 3(D). By making the surface of the MgO (001) barrier layer 21 flat and clean by annealing under ultrahigh vacuum, Fe atoms can be disposed above the O atoms of MgO on the surface. The growth of the Fe (001) upper electrode (secondary electrode) 23 was followed by the deposition of an $Ir_{0.2}Mn_{0.8}$ layer with a thickness of 10 nm on the Fe (001) upper electrode (secondary electrode) 23. The $Ir_{0.2}Mn_{0.8}$ layer 25 is used for enhancing the exchange bias field of the Fe (001) upper electrode 23 so that an antiparallel magnetization alignment can be realized.

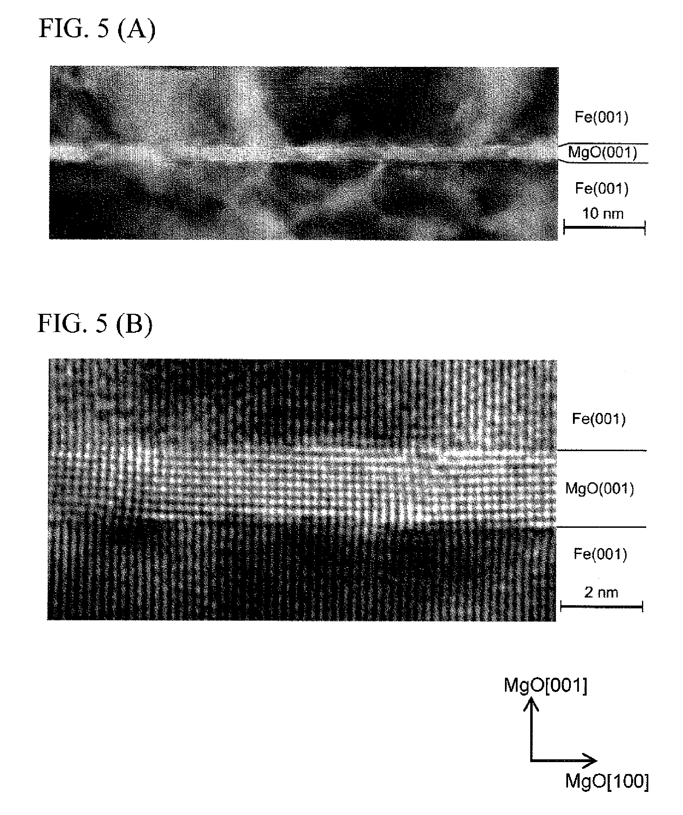

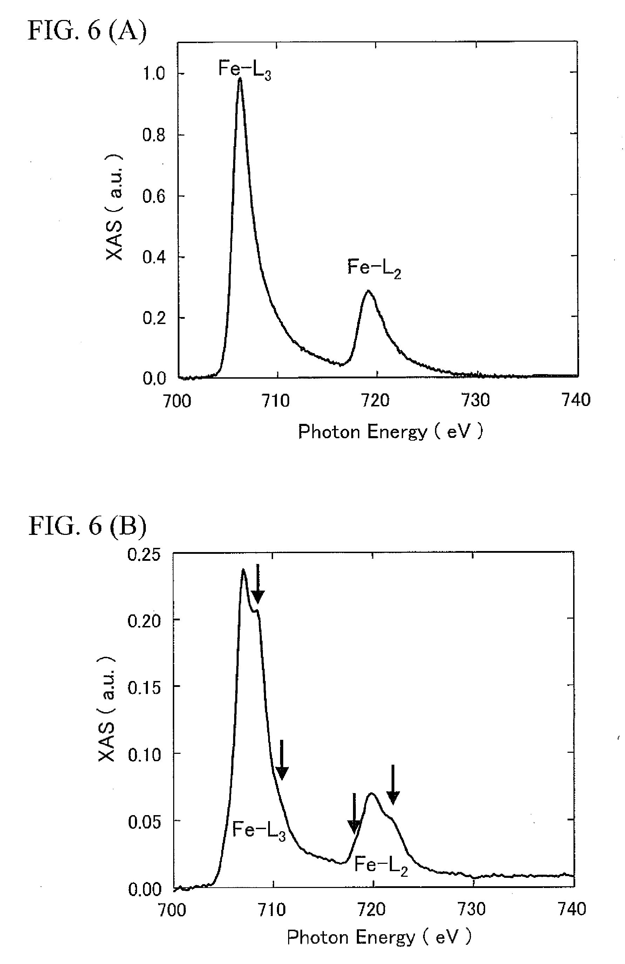

Fig. 5 shows transmission electron microscope images of the thus manufactured device. Fig. 5(B) shows an enlarged photo of Fig. 5(A). It will be seen from these photos that good crystallinity and interface structure are realized. Fig. 6(A) shows the X-ray absorption spectrum (XAS) at L2 and L3 absorption edges of the Fe atoms in the first atomic layer of the interface. The spectrum of Fig. 6(A) shows that the L2 and L3 absorption edges each have a single peak. This indicates that the Fe atoms in the interface are not oxidized and that an ideal interface structure as shown in Fig. 1(A) is realized.

Fig. 6(B) shows the X-ray absorption spectrum (XAS) of a device in which the Fe (001) upper electrode (secondary electrode) 23 was deposited at room temperature without performing the ultrahigh-vacuum annealing of the MgO (001) barrier layer 21. The spectrum in Fig. 6(B) shows that the L2 and L3 absorption edges do not have single peaks but they each have shoulders at the peak (as indicated by the arrows). Because these spectral shapes are unique to Fe oxides ($FeO_x$) (see J. P. Crocombette, et al., Phys. Rev. B52, 3143 (1995)), it is thought that the interface structure is as shown in Fig. 1(C).

Thereafter, the above-prepared sample is subjected to micro fabrication so as to obtain a Fe (001)/MgO (001)/Fe (001) MTJ device.

The aforementioned MgO evaporation by electron beam evaporation was performed under ultrahigh-vacuum of $10^{-9}$ Torr. In this method, a colorless, transparent and good thin film can be formed even when the film is formed on a glass substrate to the thickness of 300 nm.

Based on the results of observation of the quadrupole mass spectrum in the film growth chamber during MgO growth, it can be seen that the partial pressures regarding the spectra of O and $O_2$ are high. Further, regarding the film deposition-rate dependence of oxygen partial pressure during MgO evaporation, it can be seen that oxygen partial pressure itself is rather high and that it increases with the deposition rate. These suggest the decomposition of oxygen from the MgO crystal during the deposition of MgO, indicating the possibility of oxygen deficiency, such as in $MgO_x$ ($0.9 < x < 1$). If there is oxygen deficiency, the MgO tunnel barrier height could presumably be lowered, which would result in an increase in tunneling current. In the case of a usual Al-O tunnel barrier, the tunnel barrier height with respect to Fe (001) electrodes is known to be from 0.7 to 2.5 eV. Meanwhile, an ideal tunnel barrier height for the MgO crystal is 3.6 eV, and experimental values of 0.9 to 3.7 eV have been obtained. When the method of the present embodiment is used, a tunnel barrier height of 0.3 to 0.4 eV is estimated, which indicates that the resistance of the magnetic tunnel junction device can be reduced. However, the low barrier height can also be related to other factors, such as the aforementioned influence of a coherent tunneling. The value of x in $MgO_x$ based on oxygen deficiency is such that $0.98 < x < 1$, and preferably $0.99 < x < 1$. These ranges exclude Mg elementary substance and are such that the MgO characteristics can be basically maintained.

The aforementioned tunnel barrier height $\phi$ was determined by fitting the electric conductance characteristics of the MTJ device (the relationship between tunnel current density J and bias voltage V) onto the Simmons' formula (Equation (20) in a non-patent document by J. G. Simmons: J. Appl. Phys. 34, pp. 1793-1803 (1963)) based on the WKB approximation, using the least squares method. The fitting was performed using the mass of a free electron (m = 9.11 $\times 10^{-31}$ kg) as the electron's effective mass. When a bias voltage V (which is normally on the order of 500 mV to 1000 mV) is applied until non-linearity appears in the J-V characteristics, the height $\phi$ of the tunnel barrier and the effective thickness $\Delta s$ of the tunnel barrier can be simultaneously determined by fitting the J-V characteristics using the Simmons' formula.

The effective thickness $\Delta s$ of the tunnel barrier was determined to be smaller than the actual thickness of the MgO (001) tunnel barrier layer ($t_{MgO}$) determined from a cross-sectional transmission electron microscope image of the MTJ device by approximately 0.5 nm. This is due to the effective thickness $\Delta s$ of the tunnel barrier having been reduced from the actual MgO(001) layer thickness by the effect of the image potential formed in the boundary between the MgO (001) layer and the alloy layer consisting mainly of Fe and Co.

It is noted that, in the event that $t_{MgO}$ can be accurately determined using the cross-sectional TEM image, the height $\phi$ of the tunnel barrier can be more simply estimated by the following technique. Namely, when the bias voltage V applied to the MTJ device is small (normally 100 mV or smaller), tunnel current density J is nearly proportional to bias voltage V, such that the J-V characteristics become linear. In such a low-bias voltage region, the Simmons' formula can be described as follows:

$$J = [(2m\phi)^{1/2}/\Delta s](e/h)^2 \times \exp[-(4\pi\Delta s/h) \times (2m\phi)^{1/2}] \times V \qquad (2)$$

where m is the mass of a free electron ($9.11 \times 10^{-31}$ kg), e is elementary charge ($1.60 \times 10^{-19}$ C), and h is the Planck's

constant ($6.63 \times 10^{-34}$ J·s). The effective thickness of the tunnel barrier $\Delta s$ is approximately $t_{MgO}$ - 0.5 nm. By fitting the J-V characteristics of the MTJ device in the low-bias voltage region onto Equation (2), the height $\phi$ of the tunnel barrier can be simply and yet accurately estimated.

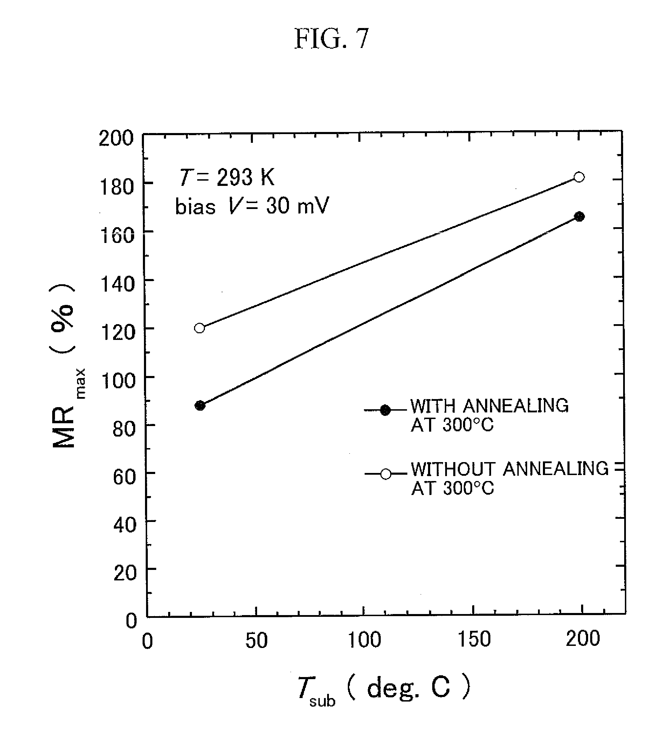

Fig. 7 shows the dependence the maximum value $MR_{max}$ of the MR ratio on the growth temperature Ts of the Fe (001) upper electrode (secondary electrode) 23, in a case where annealing at 300°C was performed in ultrahigh vacuum (indicated by white dots) and a case where such annealing was not performed (indicated by black dots). The $MR_{max}$ was measured at room temperature (293K), and the applied voltage was 30 mV. As shown in Fig. 7, the $MR_{max}$ is greater when the annealing process was performed than when it was not. It is also seen that $MR_{max}$ increases as the growth temperature Ts of the Fe (001) upper electrode (secondary electrode) 23 increases. A very large $MR_{max}$ value of approximately 180% was obtained when Ts = 200°C and annealing was performed at 300°C.

Thus, a high $MR_{max}$ value was obtained when annealing was performed. This is believed due to the fact that, as mentioned above, the MgO (001) barrier layer 21 can be made flat and clean by annealing at ultrahigh vacuum, whereby adsorbed water or oxygen can be removed from the surface by annealing, resulting in a clean surface condition where the Fe atoms are disposed above the O atoms of the MgO on the surface. Other factors will be described later.

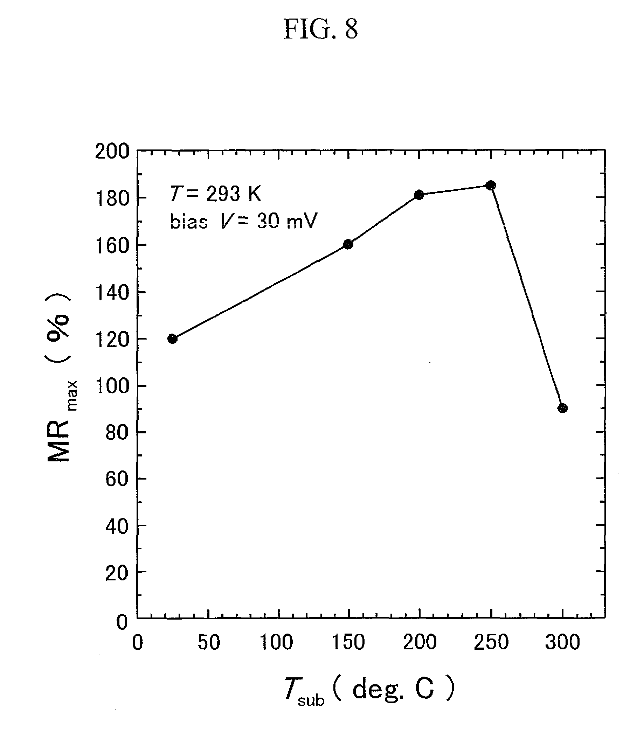

Fig. 8 shows the same graph as that of Fig. 7 plotted from a different perspective. The graph of Fig. 8 shows the $T_{sub}$ dependence of $MR_{max}$ when the MgO (001) tunnel barrier was grown and annealed at 300°C under ultrahigh vacuum, and then the Fe (001) upper electrode (secondary electrode) 23 was grown at the substrate temperature $T_{sub}$. As shown in Fig. 8, $MR_{max}$ is 120% when substrate temperature $T_{sub}$ is 25°C (room temperature); 155% when $T_{sub}$ is 150°C; 180% when $T_{sub}$ is 200°C; 186% when $T_{sub}$ is 250°C; and 90% when $T_{sub}$ is 300°C. These results show that the growth temperature for the growth of the Fe (001) upper electrode (secondary electrode) 23 following annealing at 300°C is preferably approximately from 150 to 250°C. When the growth temperature is 300°C, the Fe (001) upper electrode (secondary electrode) 23 grew in a granular manner. The low $MR_{max}$ is believed due to the failure to achieve antiparallel magnetization alignment.

The thickness of the grown barrier layer was measured from a high-resolution transmission electron microscope (TEM) image of the device cross-section. Specifically, the distance between the boundary of the lower electrode layer and the tunnel barrier layer and the boundary of the tunnel barrier layer and the upper electrode layer was estimated from the TEM image and defined as the thickness ($t_{MgO}$) of the barrier layer. When there was a film thickness distribution due to the roughness of the barrier layer, an average MgO thickness was used as the thickness of the barrier layer.

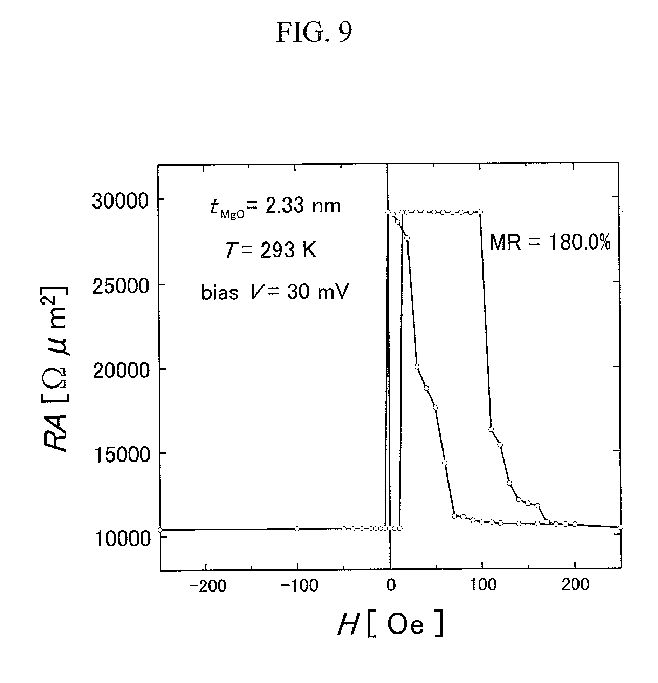

Fig. 9 shows an example of the magnetoresistance curve of the MTJ device made by the above method. Production conditions included annealing at 300°C in ultrahigh vacuum following the growth of the MgO (001) tunnel barrier, and the growth of the Fe (001) upper electrode at substrate temperature of 200°C. The barrier thickness $t_{MgO}$ of the MgO (001) barrier was 2.33 nm, measurement temperature was 293K, and the voltage applied was 30 mV. Under these film thickness conditions, a very large MR value of 180% was obtained.

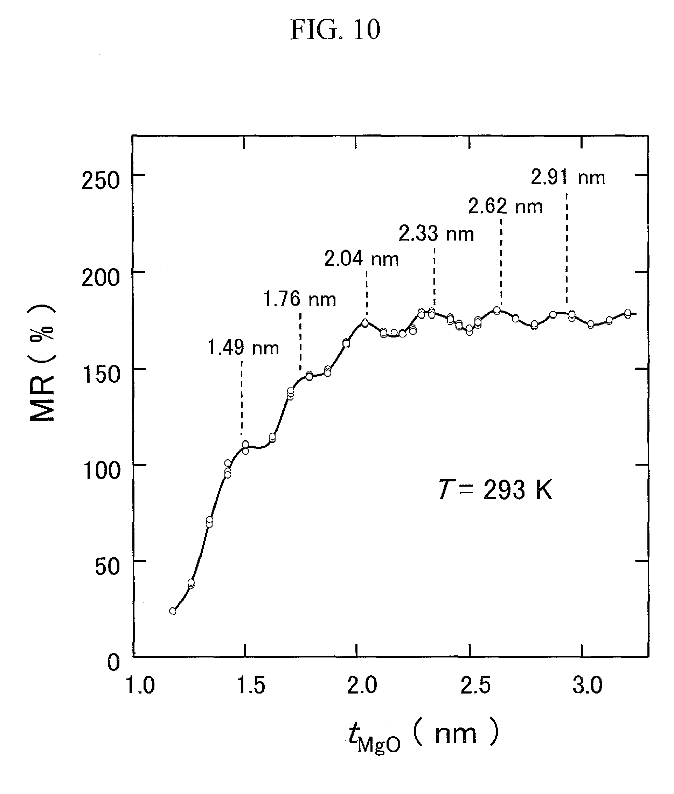

Fig. 10 shows the $t_{MgO}$ dependence of MR ratio in a case where a wedge-shaped MgO (001) barrier layer was formed on a single substrate and then the MgO (001) film thickness $t_{MgO}$ was finely varied between 1.15 nm and 3.40 nm. As shown, a considerable periodic property was observed in which peaks and valleys repeatedly appear at periods of approximately 0.15 nm. The peaks are observed at 1.49 nm, 1.76 nm, 2.04 nm, 2.33 nm, 2.62 nm, and 2.91 nm. Because the measurement error of the MgO (001) film thickness $t_{MgO}$ was approximately $\pm 0.025$ nm in the present experiment, the periodicity in peak positions, namely, the 0.3 nm period, is significant. The value of useful $t_{MgO}$ such that the MR ratio has a local maximum value is preferably 1.49 nm, 1.76 nm, 2.04 nm, 2.33 nm, 2.62 nm, or 2.91 nm, with a margin of approximately between -0.05 nm to +0.10 nm for each of the values. Specifically, when the peak position of the MR ratio is $t_{MgO}$ (p), the film thickness preferably ranges from $t_{MgO}$ (p) - 0.05 nm to $t_{MgO}$ (p) +0.10 nm, and more preferably from $t_{MgO}$ (p) to $t_{MgO}$ (p) +0.5 nm.

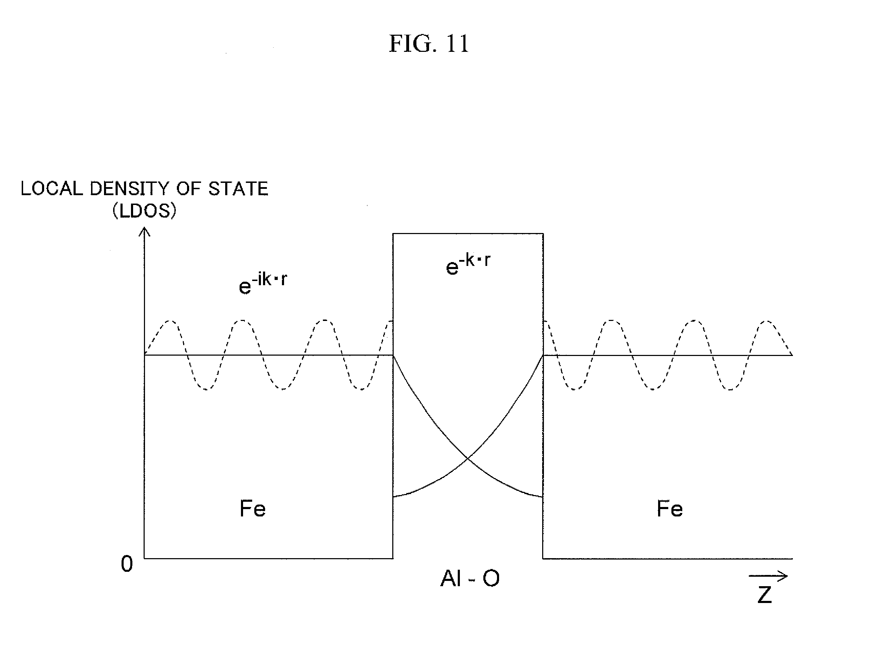

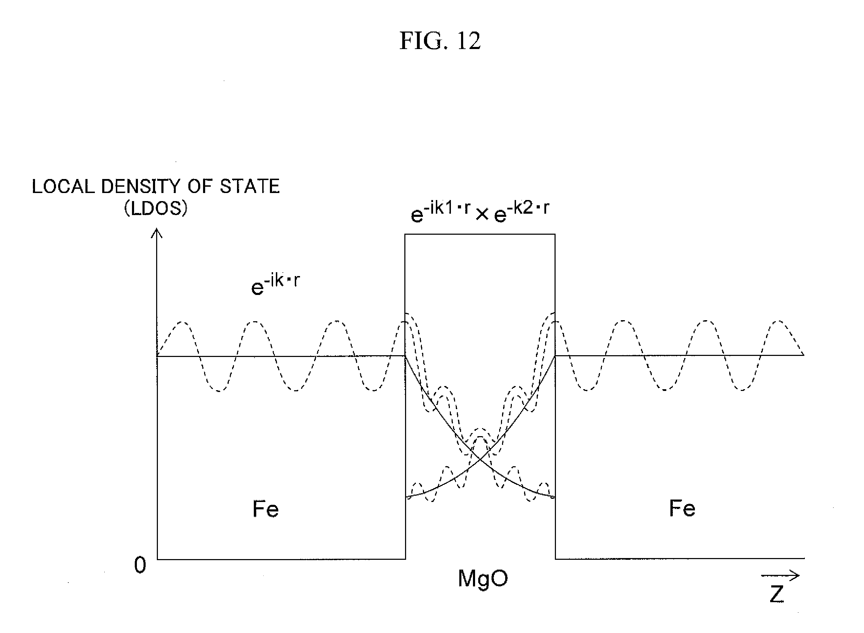

Figs. 11 and 12 show conceptual charts with reference to which the inventors' theoretical analysis regarding the oscillation of the MR ratio with respect to the MgO (001) film thickness $t_{MgO}$ has been conducted. Fig. 11 shows the local density of state (LDOS) (solid line) and the phase of wave function (broken line) at individual positions in a conventional Fe/Al-O/Fe tunnel junction structure. Fig. 12 shows the local density of state (LDOS) (solid line) and the phase of wave function (broken line) at individual positions in a Fe/MgO/Fe tunnel junction structure according to the present embodiment.

With reference to Fig. 11 showing the conventional Fe/Al-O/Fe tunnel junction structure, the phase component $e^{-ik \cdot r}$ is involved with regard to the LDOS of Fe on the incident side. However, the local density of state in the Al-O band is determined solely by the real component $e^{-k \cdot r}$ of the wave function and the imaginary component is not involved. This is due to the fact that the electronic states in the Al-O band gap are of the single-band structure. Thus, the LDOS in the Al-O barrier monotonously decreases from the incident side to the emerging side of the wave exponentially. Although r = (x, y, z), and k = (kx, ky, kz), only the z direction is now being focused. The wave function LDOS on the opposite side (on the right-hand side of Fig. 11) can also be represented by a simple decay curve. Thus, the tunnel probability in the Al-O barrier varies relatively simply with respect to the thickness of the Al-O barrier.

On the other hand, in the Fe/MgO/Fe tunnel junction structure as shown in Fig. 12, the phase component $e^{-ik \cdot r}$

is involved with regard to the LDOS of Fe on the incident side. In the MgO band gap, the electron states are of the multiband structure where electrons in the $\Delta 1$ and $\Delta 5$ bands are involved, as described with reference to Fig. 12. As a result, the product of the real component and the imaginary component of the wave function, namely, $e^{-k1 \cdot r} \cdot e^{-ik2 \cdot r}$, is involved in the MgO barrier. Thus, the imaginary component is also involved and therefore the LDOS in the MgO band decays from the wave-incident side while the coherency of the wave function is conserved from the Fe side. The LDOS of the wave function on the opposite side (on the right-hand side of Fig. 12) also decays while maintaining the wave coherency. Thus, the tunneling probability in the MgO barrier oscillates with reference to the thickness of the MgO barrier due to the interference effect by the both waves. The fact that the MR oscillation has been observed as shown in Fig. 10 signifies the superiority of the crystallinity and flatness of the MgO barrier made by the method of the present embodiment.

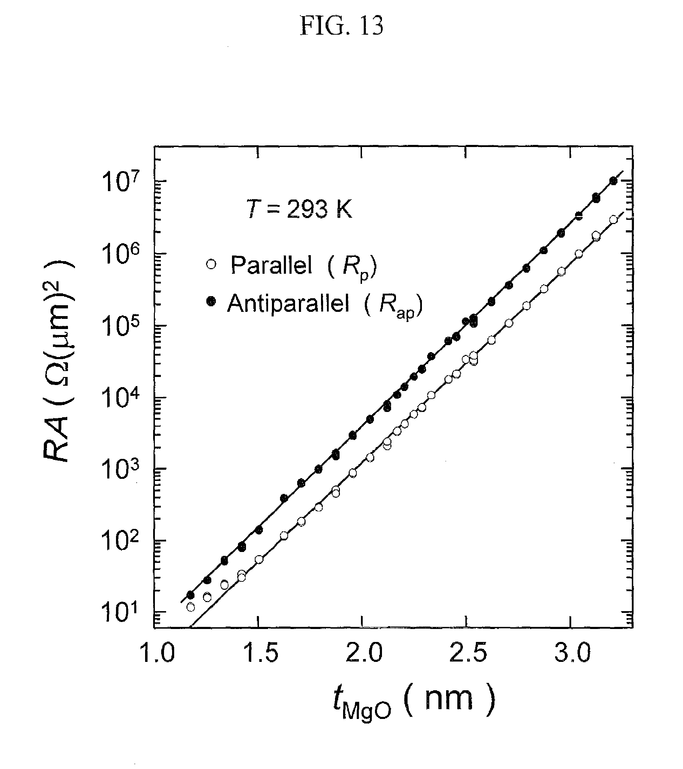

Fig. 13 shows the $t_{MgO}$ dependence of the resistivity of the MTJ device per $1\mu\,m^2$, namely, the resistance-area product RA $(\Omega(\mu m)^2)$, in a case where the upper electrode Fe (001) was grown at substrate temperature of 200°C following the growth of an MgO (001) tunnel barrier and annealing at 300°C in ultrahigh vacuum. The vertical axis shows logarithmic plots. The measurement temperature T was 293K, and the applied voltage during measurement was 30 mV. White open ciscles indicate resistance R in the case of parallel magnetization alignment, and solid ciecles indicate R in the case of antiparallel magnetization alignment. It is seen from Fig. 13 that RA increases substantially exponentially with respect to $t_{MgO}$ both in the case of parallel magnetization and antiparallel magnetization aligments.

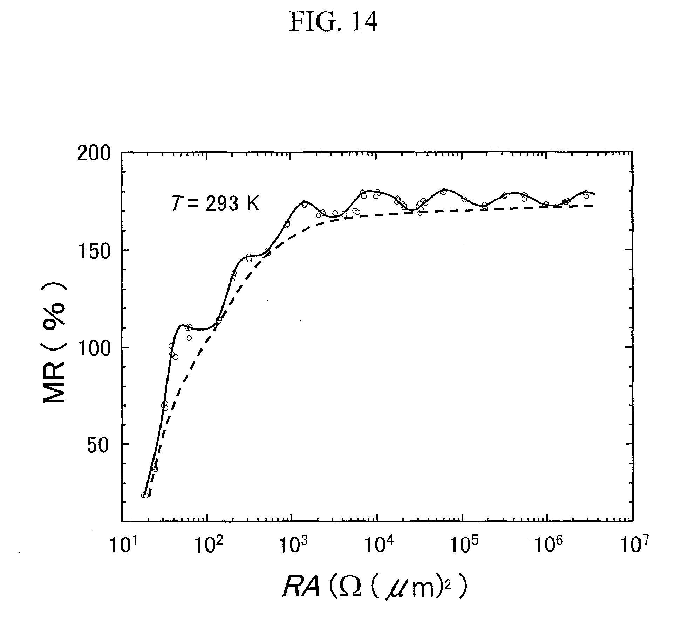

Fig. 14 shows the dependence of the MR ratio on the resistance-area product (RA) of the MTJ device determined on the basis of the experimental results shown in Figs. 10 and 13. As shown by the solid line along the plots, MR ratio exhibits a periodic oscillation based on the oscillation shown in Fig. 10. The broken line shows the RA dependence of MR ratio in a case with an assumption that the oscillation shown in Fig. 10 does not exist. It is seen that MR ratio simply increases with respect to RA when the absence of oscillation is assumed. This shows that an MR enhancement effect can be obtained by the oscillation arising from the multiband structure of the MgO (001) barrier, which is an oscillation due to the influence of the imaginary component of wave function that causes the interference of the wave functions of the electrons in the $\Delta 1$ (s electrons) band. When a MTJ device is used as a memory cell, the resistance-area product RA required for given levels of integration differs. For example, when a RA value of approximately $10^2\ \Omega\mu m^2$ is required, the monotonously decreasing curve shown by the broken line indicates that MR would be greatly varied by even a slight variation in the MgO thickness, which is not desirable from the viewpoint of integrated circuit designing. In contrast, as shown in Fig. 14, when flat MR regions exist due to the MR enhancement, a substantially uniform and high MR value can be obtained within a certain range, which makes it easier to ensure margin when designing integrated circuits (see Fig. 17).

Although Fe (001) of the BCC structure has been used in the above embodiment, Fe alloys of BCC, such as Fe-Co alloy, Fe-Ni alloy, or Fe-Pt alloy, for example, may be used instead. Alternatively, Co or Ni layers with a thickness of one or several atoms may be disposed between the electrode layer and the MgO (001) barrier layer. When a voltage is applied to the MTJ device, an oscillation of MR ratio with respect to voltage arising from the above-described oscillation is observed. The oscillation component can be accurately observed by measuring the second derivative of the J-V curve, for example.

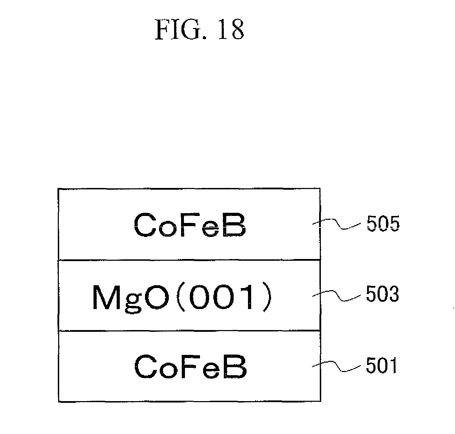

A magnetic tunnel junction device according to a variation of the first embodiment of the invention is described with reference to the drawings. Fig. 18 shows the structure of a MTJ device according to the variation, the drawing corresponding to Fig. 2(B). As shown in Fig. 18, the magnetic tunnel junction device of the variation is characterized in that, as in the magnetic tunnel junction device of the foregoing embodiment, the electrodes disposed on either side of a single-crystalline $MgO_x$ (001) or a poly-crystalline $MgO_x$ (0 < x < 1) layer 503 in which the (001) crystal plane is preferentially oriented are comprised of amorphous ferromagnetic alloy, such as CoFeB layers 501 and 505, for example. Amorphous ferromagnetic alloy can be formed by vacxuum evaporation or sputtering, for example. The resultant characteristics are substantially identical to those of the first embodiment. Examples of the amorphous ferromagnetic alloy that can be used include FeCoB, FeCoBSi, FeCoBP, FeZr, and CoZr, for example. Although the amorphous ferromagnetic alloy in the electrode layers might be partially or entirely crystallized if annealing is performed after fabricating the MTJ device, this does not lead to a significant deterioration of the MR ratio. Therefore, such crystallized amorphous ferromagnetic alloy can be used in the electrode layers without any problems.

Hereafter, a magnetic tunnel junction device according to a second embodiment of the invention and a method of manufacturing the same will be described. In the method of manufacturing a MTJ device according to the present embodiment, MgO(001) is initially deposited in a poly-crystalline or amorphous state by sputtering or the like, and then an annealing process is performed such that a polycrystal in which the (001) crystal plane is oriented or a single crystal is obtained. The sputtering conditions were such that, for example, the temperature was room temperature (293K), a 2-inch $\phi$ MgO was used as a target, and sputtering was conducted in an Ar atmosphere. The acceleration power was 200 W and the growth rate was 0.008 nm/s. Because MgO deposited under these conditions is in an amorphous state, a crystallized MgO can be obtained by increasing the annealing temperature to 300°C from room temperature and maintaining that temperature for a certain duration of time.

An oxygen deficiency may be introduced by a method whereby an oxygen deficiency is produced during growth, a method whereby an oxygen deficiency is introduced subsequently, or a method whereby a state with an oxygen deficiency is subjected to an oxygen plasma process or natural oxidation so as to achieve a certain oxygen deficiency level.

As described above, in accordance with the magnetic tunnel junction device technology of the present embodiment, an annealing process is carried out for crystallization after an amorphous MgO has been deposited by sputtering, thereby eliminating the need for large-sized or elaborate equipment. For example, the height of the tunnel barrier may be adjusted by doping Ca or Sr, instead of introducing an oxygen deficiency to the MgO layer. Further, while the MgO layer has been described to be deposited by electron beam deposition or sputtering, it should be obvious that other deposition methods are also possible. The term "high vacuum" refers to values on the order of no more than $10^{-6}$ Pa in the case where oxygen is not introduced, for example. In the case where oxygen is intentionally introduced, the term refers to values on the order of $10^{-4}$ Pa.

While the magnetic tunnel junction device according to various embodiments of the invention has been described, it should be apparent to those skilled in the art that the invention is not limited to those specific embodiments and various other modifications, improvements and combinations are possible.

In accordance with the invention, a larger magnetoresistance than in the conventional MTJ device can be obtained, and the output voltage of the MTJ device can be increased. Thus, higher levels of integration for MRAM based on the MTJ device can be achieved easily.

Magnetic resistance of 188 % as a MTJ device and output voltage value of 550 mV for an MRAM, which are both very high values, were obtained, indicating that the device of the invention can be suitably applied to giga-bit class, very highly integrated MRAMs.

**Claims**

1. A magnetic tunnel junction device of a magnetic tunnel junction structure comprising:

   a tunnel barrier layer;
   a first ferromagnetic material layer of the BCC structure formed on a first plane of said tunnel barrier layer; and
   a second ferromagnetic material layer of the BCC structure formed on a second plane of said tunnel barrier layer;
   wherein said tunnel barrier layer is formed of a single-crystalline $MgO_x$ (001) or a poly-crystalline $MgO_x$ ($0 < x < 1$) layer (to be hereafter referred to as "MgO layer") in which the (001) crystal plane is preferentially oriented, and wherein the atoms of which said second ferromagnetic material layer is composed are disposed above the O atoms of said MgO tunnel barrier layer.

2. A magnetic tunnel junction device of a magnetic tunnel junction structure comprising:

   a tunnel barrier layer comprising MgO (001);
   a first ferromagnetic material layer of an alloy of the BCC structure formed on a first plane of said tunnel barrier layer, said first ferromagnetic material layer comprising Fe as a main component; and
   a second ferromagnetic material layer of an alloy of the BCC structure formed on a second plane of said tunnel barrier layer, said second ferromagnetic material layer comprising Fe as a main omponent,
   wherein said tunnel barrier layer is formed of a single-crystalline $MgO_x$ (001) or a poly-crystalline $MgO_x$ ($0 < x < 1$) layer in which the (001) crystal plane is preferentially oriented,
   wherein the atoms of which said second ferromagnetic material layer is composed are disposed above the O atoms of said MgO tunnel barrier layer.

3. A magnetic tunnel junction device of a magnetic tunnel junction structure comprising:

   a tunnel barrier layer comprising MgO (001);
   a first ferromagnetic material layer comprising Fe (001) formed on a first plane of said tunnel barrier layer; and
   a second ferromagnetic material layer comprising Fe (001) formed on a second plane of said tunnel barrier layer,
   wherein said tunnel barrier layer is formed of a single-crystalline $MgO_x$ (001) or a poly-crystalline $MgO_x$ ($0 < x < 1$) in which the (001) crystal plane is preferentially oriented,
   and wherein the Fe atoms of which said second ferromagnetic material layer is composed are disposed above the O atoms of said MgO tunnel barrier layer.

4. A magnetic tunnel junction device of a magnetic tunnel junction structure comprising:

a tunnel barrier layer;
a first ferromagnetic material layer of the BCC structure formed on a first plane of said tunnel barrier layer; and
a second ferromagnetic material layer of the BCC structure formed on a second plane of said tunnel barrier layer;
wherein said tunnel barrier layer is formed of a single-crystalline $MgO_x$ (001) or a poly-crystalline $MgO_x$ (0 < x < 1) layer (to be hereafter referred to as "MgO layer") in which the (001) crystal plane is preferentially oriented, and wherein wave functions of the Δ1 band of said ferromagnetic material layer of the BCC structure are caused to seep into said MgO layer such that the tunneling probabilities of carriers are enhanced.

5. A magnetic tunnel junction device of a magnetic tunnel junction structure comprising:

a tunnel barrier layer comprising MgO (001);
a first ferromagnetic material layer comprising an alloy of the BCC structure formed on a first plane of said tunnel barrier layer and comprising Fe as a main component; and
a second ferromagnetic material layer comprising an alloy of the BCC structure formed on a second plane of said tunnel barrier layer and comprising Fe as a main component,
wherein said tunnel barrier layer is formed of a single-crystalline $MgO_x$ (001) or a poly-crystalline $MgO_x$ (0 < x < 1) layer in which the (001) crystal plane is preferentially oriented,
and wherein wave functions of the Δ1 band of said alloy of the BCC structure are caused to seep into said MgO layer, whereby the tunneling probabilities of carriers are enhanced.

6. A magnetic tunnel junction device of a magnetic tunnel junction structure comprising:

a tunnel barrier layer comprising MgO (001);
a first ferromagnetic material layer comprising Fe (001) formed on a first plane of said tunnel barrier layer; and
a second ferromagnetic material layer comprising Fe (001) formed on a second plane of said tunnel barrier layer,
wherein said tunnel barrier layer is formed of a single-crystalline $MgO_x$ (001) or a poly-crystalline $MgO_x$ (0 < x < 1) layer in which the (001) crystal plane is preferentially oriented,
and wherein wave functions of the Δ1 band of said Fe (001) are caused to seep into said MgO layer, whereby the tunneling probabilities of carriers are enhanced.

7. The magnetic tunnel junction device according to any one of claims 1 to 6, wherein said MgO layer has a film thickness such that the tunneling magnetoresistance effect is enhanced by the interference effect of wave functions in said MgO layer.

8. The magnetic tunnel junction device according to any one of claims 1 to 7, wherein said MgO layer has a film thickness of 1.49 nm, 1.76 nm, 2.04 nm, 2.33 nm, 2.62 nm, or 2.91 nm, each with a margin of -0.05 nm to +0.10 nm.

9. The magnetic tunnel junction device according to any one of claims 1 to 7, wherein said MgO layer has a film thickness of 1. 49 nm, 1.76 n, 2.04 nm, 2.33 nm, 2.62 nm, or 2.91 nm, each with a margin of +0.05 nm.

10. The magnetic tunnel junction device according to any one of claims 1 to 9, wherein a discontinuous value (height of tunnel barrier) between the bottom of the conduction band of said tunnel barrier layer and the Fermi energy of at least one of said first or said second ferromagnetic material layer is smaller than an ideal value that would be obtained when the MgO (001) layer comprises a perfect single crystal.

11. A magnetic tunnel junction device of a magnetic tunnel junction structure comprising:

a tunnel barrier layer comprising MgO(001);
a first ferromagnetic material layer formed on a first plane of said tunnel barrier layer and comprising a single-crystalline (001) or a poly-crystalline layer of Fe or an Fe alloy of the BCC structure, said poly-crystalline layer having the (001) crystal plane preferentially oriented therein;
a second ferromagnetic material layer formed on a second plane of said tunnel barrier layer and comprising a single-crystalline (001) or a poly-crystalline layer of Fe or an Fe alloy of the BCC structure, said poly-crystalline layer having the (001) crystal plane preferentially oriented therein,
wherein the atoms of which said second ferromagnetic material layer is composed are disposed above the O atoms of said MgO tunnel barrier layer,
and wherein a discontinuous value (height of tunnel barrier) between the bottom of the conduction band of said tunnel barrier layer and the Fermi energy of at least one of said first or said second ferromagnetic material layer is smaller than an ideal value that would be obtained when the MgO (001) layer comprises a perfect single crystal.

12. The magnetic tunnel junction device according to claim 10 or 11, wherein said discontinuous value is in the range of 0.2 to 0.5 eV.

13. The magnetic tunnel junction device according to claim 10 or 11, wherein said discontinuous value is in the range of 0.10 to 0.85 eV.

14. A memory device comprising:

    a transistor; and
    the magnetic tunnel junction device according to any one of claims 1 to 13, which is used as a load for said transistor.

15. A method of manufacturing a magnetic tunnel junction device, comprising the steps of:

    forming a first single-crystalline (001) or a poly-crystalline layer of Fe or an Fe alloy of the BCC structure (to be hereafter referred to as "an Fe layer"), said poly-crystalline layer having the (001) crystal plane preferentially oriented therein;
    depositing a MgO tunnel barrier layer (to be hereafter referred to as "a tunnel barrier layer") on said first (001) layer of Fe or an Fe alloy of the BCC structure under high vacuum, said tunnel barrier layer comprising a single-crystalline $MgO_x$ (001) or a poly-crystalline $MgO_x$ (0 < x < 1) in which the (001) crystal plane is preferentially oriented, and then annealing under ultrahigh vacuum at temperature ranging from 200°C to 300°C; and
    forming a second Fe layer on said tunnel barrier layer.

16. The method of manufacturing a magnetic tunnel junction device according to claim 15, wherein said step of forming said second Fe layer on said tunnel barrier layer is performed at a substrate temperature ranging from 150°C to 250°C.

17. The method of manufacturing a magnetic tunnel junction device according to claim 15 or 16, wherein the step of forming said second Fe layer on said tunnel barrier layer is performed under conditions such that Fe is disposed above the O atoms of said MgO layer.

18. The method of manufacturing a magnetic tunnel junction device according to claim 15 or 16, wherein the step of forming said second Fe layer on said tunnel barrier layer is performed at a substrate temperature ranging from 200°C to 250°C.

19. The method of manufacturing a magnetic tunnel junction device according to any one of claims 15 to 18, wherein the step of forming said second Fe layer on said tunnel barrier layer is performed under conditions such that Fe is disposed above the O atoms of said MgO layer.

20. A method of manufacturing a magnetic tunnel junction device, comprising:

    a first step of preparing a substrate comprising a single-crystalline $MgO_x$ (001) or a poly-crystalline $MgO_x$ (0 < x < 1) in which the (001) crystal plane is preferentially oriented;
    a second step of depositing on said substrate a first single-crystalline (001) or a poly-crystalline layer of Fe or an Fe alloy of the BCC structure, said poly-crystalline layer having the (001) crystal plane preferentially oriented therein, and then annealing for surface planarization purposes;
    a third step of depositing, under high vacuum, a tunnel barrier layer on said first (001) layer of Fe or an Fe alloy of the BCC structure, said tunnel barrier layer comprising single-crystalline $MgO_x$ (001) or poly-crystalline $MgO_x$ (0 < x < 1) in which the (001) crystal plane is preferentially oriented, and then annealing at temperature ranging from 200°C to 300°C; and
    a fourth step of forming a second single-crystalline (001) or poly-crystalline layer of Fe or an Fe alloy of the BCC structure on said tunnel barrier layer, said poly-crystalline layer having the (001) crystal plane preferentially oriented therein.

21. The method of manufacturing a magnetic tunnel junction device according to claim 20, wherein the fourth step is performed at a substrate temperature ranging from 150°C to 250°C.

22. The method of manufacturing a magnetic tunnel junction device according to claim 20, wherein the step of forming said second Fe layer on said tunnel barrier layer is performed under conditions such that Fe is disposed above the O atoms of said MgO layer.

23. The method of manufacturing a magnetic tunnel junction device according to claim 20, further comprising a step between said first and said second steps of causing the growth of a seed layer comprising a single-crystalline $MgO_x$ (001) or a poly-crystalline $MgO_x$ ($0 < x < 1$) in which the (001) crystal plane is preferentially oriented.

24. A magnetic tunnel junction device of a magnetic tunnel junction structure comprising:

   a tunnel barrier layer;
   a first ferromagnetic material layer comprising an amorphous magnetic alloy formed on a first plane of said tunnel barrier layer; and
   a second ferromagnetic material layer comprising an amorphous magnetic alloy formed on a second plane of said tunnel barrier layer,
   wherein said tunnel barrier layer is formed of a single-crystalline $MgO_x$ (001) or a poly-crystalline $MgO_x$ ($0 < x < 1$) layer in which the (001) crystal plane is preferentially oriented (to be hereafter referred to as "a MgO layer"),
   wherein wave functions of conduction electrons in at least one of said first or said second ferromagnetic material layer are caused to seep into the $\Delta 1$ band of said MgO layer such that the tunneling probabilities of carriers are enhanced.

25. The magnetic tunnel junction device according to claim 24, wherein said MgO layer has a film thickness such that the tunneling magnetoresistance effect is enhanced by the interference effect of the wave functions in said MgO layer.

26. The magnetic tunnel junction device according to claim 24 or 25, wherein the film thickness of said MgO (001) is 1.49 nm, 1.76 nm, 2.04 nm, 2.33 nm, 2.62 nm, or 2.91 nm, each with a margin of approximately -0.05 nm to +0.10 nm.

27. The magnetic tunnel junction device according to claim 24 or 25, wherein the film thickness of said MgO (001) is 1.49 nm, 1.76 nm, 2.04 nm, 2.33 nm, 2.62 nm, or 2.91 nm, each with a margin of approximately +0.05 nm.

28. The magnetic tunnel junction device according to any one of claims 24 to 27, wherein a discontinuous value (height of tunnel barrier) between the bottom of the conduction band of said tunnel barrier layer and the Fermi energy of at least one of said first or said second ferromagnetic material layer is smaller than an ideal value that would be obtained when the MgO (001) layer comprises a perfect single crystal.

29. A magnetic tunnel junction device of a magnetic tunnel junction structure comprising:

   a tunnel barrier layer;
   a first ferromagnetic material layer comprising an amorphous magnetic alloy formed on a first plane of said tunnel barrier layer; and
   a second ferromagnetic material layer comprising an amorphous magnetic alloy formed on a second plane of said tunnel barrier layer,
   wherein said tunnel barrier layer is formed of a single-crystalline $MgO_x$ (001) or a poly-crystalline $MgO_x$ ($0 < x < 1$) layer in which the (001) crystal plane is preferentially oriented (to be hereafter referred to as "a MgO layer"),
   wherein wave functions of conduction electrons in at least one of said first or said second ferromagnetic material layer are caused to seep into the $\Delta 1$ band of said MgO layer such that the tunneling probabilities of carriers are enhanced one another,
   and wherein a discontinuous value (height of tunnel barrier) between the bottom of the conduction band of said tunnel barrier layer and the Fermi energy of at least one of said first or said second ferromagnetic material layer is smaller than an ideal value that would be obtained when the MgO (001) layer comprises a perfect single crystal.

30. The magnetic tunnel junction device according to claim 28 or 29, wherein said discontinuous value is in the range of 0.2 to 0.5 eV.

31. The magnetic tunnel junction device according to claim 28 or 29, wherein said discontinuous value is in the range of 0.10 to 0.85 eV.

32. A memory device comprising:

a transistor; and
the magnetic tunnel junction device according to any one of claims 24 to 31, which is used as a load for said transistor.

⊘ : Fe atom    ○ : O atom    ● : Mg atom

## FIG. 1 (A)

Fe layer

MgO layer

← Fe atomic layer at interface

Fe[001] direction

Fe[100] direction

## FIG. 1 (B)

Fe layer

MgO layer

← Fe atomic layer at interface

## FIG. 1 (C)

Fe layer

MgO layer

← Fe atomic layer at interface

## FIG. 2 (A)

$E - E_F \, (\text{eV})$

[001] DIRECTION

$\Delta_{1\downarrow}$

$\Delta_{1\uparrow}$

Fe

## FIG. 2 (B)

5 ⟶ Fe(001)

3 ⟶ MgO(001)

1 ⟶ Fe(001)

## FIG. 3 (A)

15 MgO(001)
SEED LAYER

MgO(001) SUBSTRATE

11

## FIG. 3 (B)

ANNEAL (350°C)

17 Fe(001) LOWER ELECTRODE
(100nm)

15

11

## FIG. 3 (C)

21 MgO(001) BARRIER LAYER
(1.2 to 3.4nm)

17

15

11

## FIG. 3 (D)

25 $In_{0.2}Mn_{0.8}$ (10nm)

23 Fe(001) UPPER ELECTRODE
(10nm)

21

17

15

11

FIG. 4 (A)

FIG. 4 (B)

FIG. 5 (A)

Fe(001)

MgO(001)

Fe(001)

10 nm

FIG. 5 (B)

Fe(001)

MgO(001)

Fe(001)

2 nm

MgO[001]

MgO[100]

FIG. 6 (A)

FIG. 6 (B)

FIG. 7

FIG. 8

## FIG. 9

FIG. 10

FIG. 11

LOCAL DENSITY OF STATE
(LDOS)

$e^{-ik \cdot r}$

$e^{-k \cdot r}$

Fe

Al - O

Fe

0

$\overrightarrow{Z}$

EP 1 793 434 A1

FIG. 12

FIG. 13

FIG. 14

# FIG. 15 (A)

ELECTRODES (FERROMAGNETIC METAL)

TUNNEL BARRIER (OXIDE)

# FIG. 15 (B)

## FIG. 16 (A)

BIT LINE

WORD LINE

## FIG. 16 (B)

WORD LINE

BIT LINE

MTJ device

MOS FET

## FIG. 16 (C)

BIT LINE

MTJ device 117

WRITE LINE

113

GND

115

100

Word Line

111

103

n⁺

n⁺

105

p

101

MOSFET 100

## FIG. 17

MAGNETORESISTANCE

CHARACTERISTICS REQUIRED
FOR Gbit-MRAM

L2

CHARACTERISTICS OF
CONVENTIONAL MTJ device

L1

0

APPLIED VOLTAGE

THIS AREA = OUTPUT VOLTAGE

FIG. 18

| | |
|---|---|
| CoFeB | ~ 505 |
| MgO(001) | ~ 503 |
| CoFeB | ~ 501 |

## INTERNATIONAL SEARCH REPORT

| International application No. |
| --- |
| PCT/JP2005/015044 |

A. CLASSIFICATION OF SUBJECT MATTER
*H01L43/10* (2006.01), *H01L43/08* (2006.01), *H01L43/12* (2006.01), *H01L27/105* (2006.01)

According to International Patent Classification (IPC) or to both national classification and IPC

B. FIELDS SEARCHED

Minimum documentation searched (classification system followed by classification symbols)
*H01L43/10* (2006.01), *H01L43/08* (2006.01), *H01L43/12* (2006.01), *H01L27/105* (2006.01)

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
Science Citation Index Expanded(Web of Science)

C. DOCUMENTS CONSIDERED TO BE RELEVANT

| Category* | Citation of document, with indication, where appropriate, of the relevant passages | Relevant to claim No. |
| --- | --- | --- |
| X<br>A | W.H. Butler et al., Spin-dependent tunneling conductance of Fe\|MgO\|Fe sandwiches, Physical Review B, Vol.63, 054416, 08 January, 2001 (08.01.01), full text | 1-7,14,24, 25,32<br>8-13,15-23, 26-31 |
| X<br>A | H.L. Meyerheim et al., Geometrical and Compositional Structure at Metal-Oxide Interfaces: MgO on Fe (001), Physical Review Letters, Vol.87, No.7, 076102, 13 August, 2001 (13.08.01), full text | 1-7,14,24, 25,32<br>8-13,15-23, 26-31 |

☐ Further documents are listed in the continuation of Box C.   ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>10 November, 2005 (10.11.05) | Date of mailing of the international search report<br>22 November, 2005 (22.11.05) |
| --- | --- |
| Name and mailing address of the ISA/<br>Japanese Patent Office | Authorized officer |
| Facsimile No. | Telephone No. |

Form PCT/ISA/210 (second sheet) (April 2005)

**EP 1 793 434 A1**

## INTERNATIONAL SEARCH REPORT

International application No.

PCT/JP2005/015044

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

The inventions in claims 1-3, 7-14, 17, 19, 22 relate to "a magnetoresistance element characterized by arranging atoms constituting a second ferromagnetic layer on O in an MgO tunnel barrier layer".

The inventions in claims 4-6, 24-32 relate to "a magnetoresistance element using the Δ 1-band wave motion function of a BCC-structure ferromagnetic layer that seeps into an MgO layer to thereby allow the tunnel probabilities of a carrier to strengthen each other".

(continued to extra sheet)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest and, where applicable, the payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

**INTERNATIONAL SEARCH REPORT**

International application No.

PCT/JP2005/015044

Continuation of Box No.III of continuation of first sheet(2)

The inventions in claims 15, 16, 18, 20-21, 23 relate to "a production method for a magnetoresistance element comprising the steps of forming on an Fe layer under high vacuum a tunnel barrier layer consisting of polycrystalline MgOx (0<x, 1) in which a single-crystal MgOx (001) or (001) crystal plane is priority-oriented, and then annealing it at a specified temperature under ultra-high vacuum".

Form PCT/ISA/210 (extra sheet) (April 2005)

**EP 1 793 434 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. WANG et al.** *Science,* 2001, vol. 294, 1488
- **W. WULFHEKEL et al.** *Appl. Phys. Lett.,* 2001, vol. 78, 509
- **W. H. BUTLER ; X. G. ZHANG et al.** *Phys. Rev. B,* 2001, vol. 63, 054416
- **H. L. MEYERHEIM et al.** *Phys. Rev. Lett.,* 2001, vol. 87, 76102
- **H. L. MEYERHEIM et al.** *Phys. Rev. B.,* 2002, vol. 65, 144433
- **X. G. ZHANG ; W. H. BULTER et al.** *Phys. Rev. B.,* 2003, vol. 68, 92402
- **J. P. CROCOMBETTE et al.** *Phys. Rev. B,* 1995, vol. 52, 3143
- **J. G. SIMMONS.** *J. Appl. Phys.,* 1963, vol. 34, 1793-1803